Europäisches Patentamt

European Patent Office

Office européen des brevets

(11) Numéro de publication: **0 387 745**
**A1**

## DEMANDE DE BREVET EUROPEEN

(21) Numéro de dépôt: **90104618.5**

(22) Date de dépôt: **12.03.90**

(51) Int. Cl.⁵: **H03B 5/18**

(30) Priorité: **15.03.89 FR 8903412**

(43) Date de publication de la demande:
**19.09.90 Bulletin 90/38**

(84) Etats contractants désignés:
**DE ES FR GB IT NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(72) Inventeur: **Martheli, Michel**
**14bis, rue des Blanchards**
**F-95000 Jouy Le Moutier(FR)**

(74) Mandataire: **Weinmiller, Jürgen et al**
**Lennéstrasse 9 Postfach 24**
**D-8133 Feldafing(DE)**

(54) **Oscillateur hyperfréquence commande en tension.**

(57) Oscillateur hyperfréquence commandé en tension, ou VCO, pouvant être à commande unique, ou à double-commande.

Son circuit d'accord (6) comporte trois varactors en série (13, 14, 15). Ces varactors sont prévus, avec leurs boîtiers, pour fonctionner à des fréquences notablement inférieures. Une capacité (16) en parallèle, ce qui permet d'élargir, de manière réglable, la bande du VCO. Une capacité (17) règle la fréquence centrale d'oscillation. Une ligne ajustable (12) règle la sensibilité faible-pente.

La présente invention se rapporte à un oscillateur hyperfréquence commandé en tension, plus communément appelé "VCO" (en anglais "Voltage Controlled Oscillator").

Un VCO hyperfréquence est un oscillateur microondes dont la fréquence d'oscillation est commandable en tension. Comme état de la technique peuvent par exemple être cités les documents US-A-4.736.169 et US-A-4.684.904, qui concernent tous deux des VCO double-pente, possédant deux accès de tension de commande distincts :
. un accès de commande à forte pente, ou accès de règlage gros ("coarse tune") ;
. un accès de commande à faible pente, ou accès de règlage fin ("fine tune").

L'invention s'applique néanmoins aux VCO en général, qu'ils soient à double-pente ou non.

Les VCO connus actuellement, tel que par exemple celui décrit dans le document US-A-4.684.904 précité, s'ils présentent une bonne qualité spectrale, ont pour inconvénient de ne pas être capables de balayer une largeur de bande supérieure à 15 %, alors que dans certaines applications, il est souhaité que le VCO puisse couvrir une largeur de bande supérieure à 40 % tout en conservant une bonne qualité spectrale.

L'invention vise à remédier à cet inconvénient. Elle se rapporte à cet effet à un oscillateur hyperfréquence commandé en tension, ou VCO, ce VCO comportant un élément actif du genre transistor ou autre, qui est règlé pour être potentiellement instable dans une bande de fréquences déterminée, et un circuit d'accord dont la phase doit être règlée pour compenser celle de ce circuit actif, ce circuit d'accord comportant au moins un circuit résonant parallèle qui est constitué par la mise en parallèle d'une capacité de règlage et d'un varactor, l'ensemble formé par ce varactor et son boîtier étant normalement prévu pour fonctionner à des fréquences notablement inférieures à celles de ce VCO.

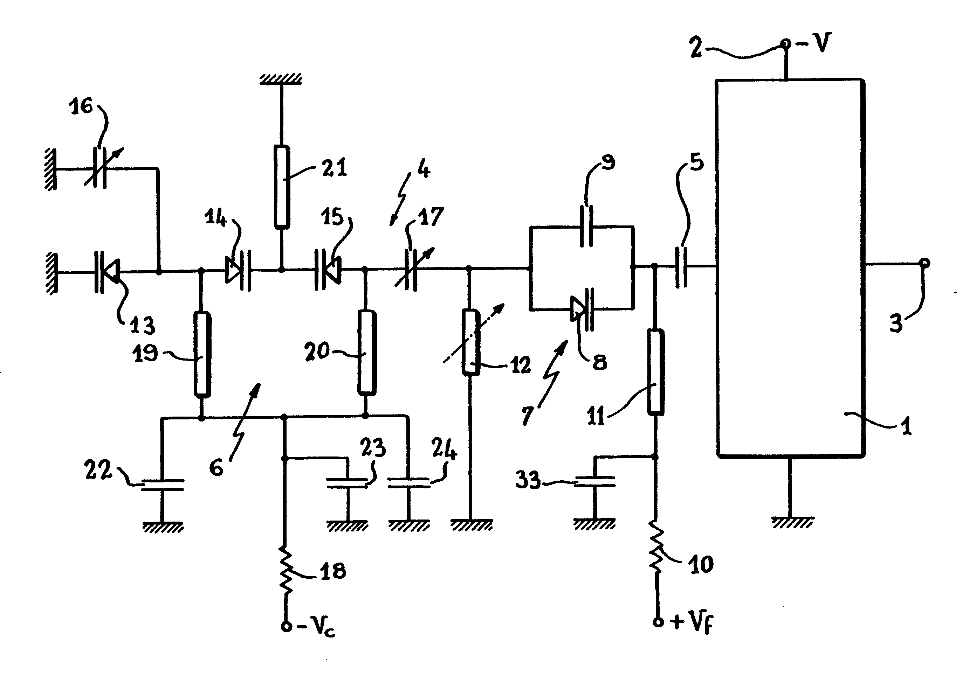

L'invention sera bien comprise, et ses avantages et autres caractéristiques ressortiront, lors de la description suivante d'un exemple non limitatif de réalisation appliqué à un VCO à double-pente, en référence à la figure unique annexée qui donne le schéma électrique de ce VCO à double-pente.

En se référant à cette figure unique, la référence 1 désigne l'élément actif de l'oscillateur, cet élément actif étant par exemple classiquement constitué par un transistor bipolaire alimenté par une tension (-V) entre la borne 2 et la masse et, de manière très classique, polarisé de façon à être potentiellement instable dans la bande de fréquences d'oscillation considérée. La sortie de l'oscillateur est prise sur la borne 3.

De manière bien connue, il y a oscillation si la phase du circuit d'accord, qui attaque le circuit actif 1 (par exemple la base du transistor bipolaire) à travers une capacité de liaison 5, vient compenser celle de ce circuit actif 1.

Le circuit d'accord 4 est constitué par la mise en série de deux circuits, dont un circuit d'accord forte-pente 6 (règlage gros) et un circuit d'accord faible-pente 7 (règlage fin).

Le circuit d'accord faible-pente 7 comporte un varactor classique 8, en parallèle avec un condensateur 9 dont la capacité est du même ordre de grandeur que celle du varactor 8 ce qui, de manière en soi connue, a pour résultat de diminuer le rapport de capacité maximale à capacité minimale aux bornes de ce varactor 8 et par suite de diminuer la sensibilité du VCO sur sa commande de faible-pente.

La tension de commande faible-pente ( + Vf) est appliquée à travers une résistance 10 et une ligne de forte impédance 11 au point de connexion entre les capacités 9 et 5. Le retour à la masse du courant de commande faible-pente s'effectue par une autre ligne de forte impédance 12. Un condensateur 33 découple les très hautes fréquences de la tension de commande faible pente Vf.

La ligne 12 ne se contente pas simplement de permettre le retour à la masse du courant de commande. Elle est interchangeable, et donc de longueur ajustable: en réglant sa longueur, il est possible de modifier la variation totale de phase du circuit d'accord obtenue en faisant varier sur une plage déterminée la tension de commande faible-pente Vf, ce qui permet d'effectuer un règlage de la sensibilité du VCO sur sa commande faiblepente.

Le circuit d'accord forte-pente 6 est constitué de la combinaison série de trois varactors 13, 14, 15, d'une faible capacité règlable 16 mise en parallèle sur le varactor 13, ainsi que d'une capacité règlable 17 qui assure la liaison avec le circuit d'accord faible-pente 6. La tension de commande forte-pente (-Vc) attaque les varactors 13 et 14 sur leur point de connexion, et le varactor 15 sur son point de connexion avec le condensateur règlable 17. Le courant de commande passe au travers de la résistance de polarisation 18, d'une ligne de forte impédance 19 relative au couple de varactors 13, 14 et d'une ligne de forte impédance 20 relative au varactor 15, et il retourne à la masse par une troisième ligne de forte impédance 21. Des capacités 22 à 24, branchées entre le point de jonction entre les éléments 18 à 20 et la masse, servent à découpler les hautes fréquences de la tension de commande forte-pente -Vc.

Les varactors 13, 14, 15, et essentiellement le varactor 13, sont très particuliers : il s'agit de varactors qui, avec les boîtiers dans lesquels ils sont montés, sont normalement prévus pour fonctionner à des fréquences notablement inférieures à celles du VCO. Pour fixer les idées, s'il s'agit d'un oscillateur prévu pour fonctionner dans la bande des 2 Gigahertz, les varactors 13 à 15 et leurs boitiers sont normalement prévus pour fonctionner aux alentours de 400 à 500 Mégahertz. En faisant fonctionner ces varactors à des fréquences notablement plus élevées que celles pour lesquelles ils sont construits, il y a dominance d'inductances "parasites" intrinsèques aux boîtiers : du point de vue hyperfréquence, ils se comportent comme des inductances et non pas comme des capacitances.

Dans ces conditions, la mise en parallèle sur le varactor "inductif" 13 de la faible capacité 16 provoque à ce niveau une résonance parallèle, ce qui a pour conséquence d'entraîner, en raison des propriétés des circuits résonants, une forte variation de la phase du circuit d'accord 6 en fonction de la fréquence, et par suite un appréciable élargissement de la largeur de bande du VCO obtenue par le circuit d'accord forte-pente 6. Le montage de trois varactors 13 à 15 en série augmente encore plus cette largeur de bande, qui parvient ainsi à atteindre une valeur nettement supérieure à 40 %.

La valeur de la capacité totale du circuit d'accord forte-pente 6 détermine la fréquence d'oscillation du VCO. Cette valeur est ajustée par la capacité variable 17 mise en série avec les varactors 13 et 15.

Le VCO présente finalement trois possibilités de règlage :

. règlage de sa largeur de bande par règlage de la valeur de la capacité 16 ;

. règlage de sa fréquence centrale d'oscillation par règlage de la valeur de la capacité 17;

. règlage de sa sensibilité sur sa commande faible-pente par ajustement de la longueur de la ligne 12.

Comme il va de soi, l'invention n'est pas limitée à l'exemple de rélisation qui vient d'être décrit. C'est ainsi que la capacité règlable 17 pourrait être remplacée par un autre varactor, ce qui finalement aboutirait à la connexion en série de quatre varactors dans le circuit d'accord forte-pente 6. Les varactors 14 et 15 pourraient être des varactors "ordinaires", c'est à dire prévus pour la bande de fréquences d'oscillation du VCO. A contrario, le varactor 8 pourrait être du même type "particulier" que le varactor 16, mais alors la capacité 9 n'aurait plus l'utilité précitée. Les polarités des tensions de commande Vc et Vf pourraient être inversées, sous condition d'inverser corrélativement chacun des varactors des circuits correspondants, et...

être potentiellement instable dans une bande de fréquences déterminée, et au moins un circuit d'accord (4) dont la phase doit être règlée pour compenser celle de ce circuit actif (1), caractérisé en ce que ce circuit d'accord (4) comporte au moins un circuit résonant parallèle (13, 16) qui est constitué par la mise en parallèle d'une capacité de règlage (16) et d'un varactor (13), l'ensemble formé par ce varactor (13) et son boîtier étant normalement prévu pour fonctionner à des fréquences notablement inférieures à celles de cet oscillateur de sorte que, aux fréquences de fonctionnement de ce dernier, cet ensemble se comporte, en raison de la dominance d'inductances parasites intrinsèques au boîtier de ce varactor (13), comme une inductance et non pas comme une capacitance.

2 - Oscillateur hyperfréquence commandé en tension selon la revendication 1, caractérisé en ce qu'il comporte, mise en série entre varactor (13) et le circuit actif (1), une capacité variable (17) apte à effectuer le règlage de la fréquence centrale d'oscillation de cet oscillateur.

3 - Oscillateur hyperfréquence commandé en tension selon la revendication 2, caractérisé en ce que cette capacité variable (17) est constituée par un autre varactor.

4 - Oscillateur hyperfréquence commandé en tension selon une des revendications 1 à 3, caractérisé en ce qu'il comporte deux autres varactors (14, 15) qui sont branchés en série avec le premier varactor (13) et qui sont commandés par la même tension de commande (-Vc).

5 - Oscillateur hyperfréquence selon la revendication 4, caractérisé en ce que ces deux autres varactors (14, 15), et leurs boitiers, sont eux-aussi prévus pour fonctionner à des fréquences notablement inférieures à celles de cet oscillateur.

6 - Oscillateur hyperfréquence selon l'une des revendications 1 à 5, cet oscillateur comportant en outre un circuit (7) de commande faible-pente apte à effectuer un règlage fin de sa fréquence d'oscillation, caractérisé en ce que ce circuit de commande faible-pente (7) comporte une ligne (12), de retour à la masse de son courant de commande, qui est ajustable de manière à effectuer un règlage de la sensibilité de cet oscillateur sur sa commande faible-pente.

## Revendications

1 - Oscillateur hyperfréquence commandé en tension, cet oscillateur comportant un circuit actif (1), du genre transistor ou autre, qui est règlé pour

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 494 929 (OREGA ELECTRONIQUE ET MECANIQUE) <br> * Figure 4; page 3, lignes 13-31; page 11, lignes 18-31 * | 1 | H 03 B 5/18 |
| A | US-A-4 736 169 (WEAVER et al.) <br> * Figure 1; colonne 4, ligne 25 - colonne 5, ligne 50 * | 1 | |
| A | US-A-4 598 423 (HETTIGER) <br> * Colonne 1, lignes 33-35 * | 1 | |
| A | MICROWAVE JOURNAL, vol. 30, no. 5, mai 1987, pages 347-348,350,352-353, Norwood, MA, US; J. KITCHEN: "Octave bandwidth varactor-tuned oscillators" <br> * Page 347, paragraphe: "Varactor diodes" * | 1 | |

|  | DOMAINES TECHNIQUES RECHERCHES (Int. Cl.5) |
|---|---|
|  | H 03 B |

Le présent rapport a été établi pour toutes les revendications

| Lieu de la recherche | Date d'achèvement de la recherche | Examinateur |
|---|---|---|
| LA HAYE | 21-06-1990 | PEETERS M.M.G. |